# EUROPEAN PATENT SPECIFICATION

(11) **EP 3 344 025 B1**
(45) Date of publication and mention of the grant of the patent: **21.04.2021**
(21) Application number: 16207334.0
(22) Date of filing: 29.12.2016
(51) Int. Cl.: H05K 7/20, H01L 23/473

(54) **FLUID-BASED COOLING ELEMENT FOR COOLING A HEAT GENERATING ELEMENT ARRANGED ON A PRINTED CIRCUIT BOARD**
FLÜSSIGKEITSBASIERTES KÜHLELEMENT ZUR KÜHLUNG EINES AUF EINER LEITERPLATTE ANGEORDNETEN WÄRMEERZEUGENDEN ELEMENTS
ÉLÉMENT DE REFROIDISSEMENT À BASE DE FLUIDE POUR REFROIDIR UN ÉLÉMENT GÉNÉRATEUR DE CHALEUR DISPOSÉ SUR UNE CARTE DE CIRCUIT IMPRIMÉ

(43) Date of publication of application: 04.07.2018
(73) Proprietor: EKWB d.o.o., 1218 Komenda (SI)
(72) Inventor: Tivadar, Niko, SI-9250 Gornja Radgona (SI)
(74) Representative: Schaumburg und Partner Patentanwälte mbB

(56) References cited:
- FR-A1- 2 316 737
- US-A- 5 168 348
- US-A- 5 323 292

## Description

The invention relates to a fluid-based cooling element for cooling a heat generating element arranged on a printed circuit board (PCB).

In state-of-the-art fluid-based cooling schemes for cooling microprocessors, integrated circuits, or other components on a printed circuit of a PCB card, water blocks or coolers for multi-phase refrigerants (i.e. refrigerant gases or chlorofluorocarbons) are either made from a single piece, are monolithic, or are made of several monolithic pieces rigidly connected to each other through which the liquid or cooling medium is circulating driven by a pressure difference.

Chips and other PCB components have their own tolerance values which differ from each other. Typical PCB components are coils, diodes, power converters and integrated circuits (chips). Certain chips of larger loading gauges have a predefined range of permitted deviations from nominal dimensions (or stack-up tolerances) which is significantly higher than for other PCB components. This is particularly the case with respect to the height of the different PCB components. The use of known fluid-based cooling elements typically set to a preadjusted base height is disadvantageous in that they cannot guarantee a sufficiently steady contact with the cooling surfaces of the PCB components to be cooled if the stack-up tolerances of the PCB components being in contact with the cooling elements are too high or are not the same. In practice, the stack-up tolerances are (as a mere example) around +/-10% the height of the respective package element (i.e. PCB component), which are calculated as being up to three times higher for relatively complex processors (e.g. +/- 0.3 mm) than for typical voltage converters (e.g. +/- 0.1 mm). This results in a sub-optimal cooling of one or more of the different PCB components to be cooled. Since the application of excessive mechanical forces is to be avoided, the sub-optimal cooling can only be compensated for by using relatively thick thermal bridge elements made, for example, of a thermal interface material (TIM). However, the use of such thermal bridge elements is associated with a relatively low heat conductivity.

A fluid-based cooling element according to the preamble of claim 1 is disclosed in US 5 168 348 A.

Thus, a general problem of known fluid-based cooling schemes is that the same are associated with a sub-optimal cooling of the PCB components to be cooled.

It is an object of the invention to specify a fluid-based cooling element for cooling a heat generating element arranged on a printed circuit board allowing for an optimal cooling of the heat generating element even in case of a relatively high stack-up tolerance of the same.

This object is solved by a fluid-based cooling element having the features of claim 1. Advantageous developments of the invention are specified in the dependent claims.

According to an embodiment, a fluid-based cooling element for cooling a heat generating element arranged on a printed circuit board is provided. The fluid-based cooling element comprises a fluid chamber for receiving a cooling fluid, a movable body, and a deformable element. The movable body is in fluidic contact with (i.e. extends until or into) the fluid chamber on an upper side of the movable body. The movable body has a base portion having a first lower surface facing away from the fluid chamber. The deformable element is in contact with the movable body for movably supporting the movable body, such that the movable body is movable towards or away from the fluid chamber in a direction perpendicular to an inner upper surface of the fluid chamber, such that the position of the first lower surface of the base portion of the movable body is adjustable in dependence on a variable height of the heat generating element arranged on the printed circuit board. In this way, a sub-optimal cooling of the heat generating element resulting from an insufficiently steady thermal and/or mechanical contact of the upper surface of the heat generating element can be avoided and thus an optimal cooling of the heat generating element will be achieved even in case of a relatively high stack-up tolerance of the same.

Preferably, the fluid-based cooling element further comprises a plurality of standoff members for fixing the fluid-based cooling element to the printed circuit board, a fixable base body, wherein the plurality of standoff members are fixed to the fixable base body, and a fining the inner upper surface of the fluid chamber. The deformable element is configured for connecting the movable body to the fixable base body. The fixable base body, the sealing body, the movable body and the deformable element together define the fluid chamber. Thus, a simple and reliable structure for a fluid-based cooling of the heat generating element can be provided.

It is advantageous when the deformable element is configured to freely move the movable body with respect to the fixable base body in a direction perpendicular to a lower surface of the fixable base body, such that the position of the first lower surface of the base portion of the movable body is displaced with respect to the position of the lower surface of the fixable base body.

Preferably, the deformable element is a membrane element extending from the lower surface of the fixable base body to a second lower surface of the base portion of the movable body. The second lower surface is recessed from the plane defined by the position of the first lower surface of the base portion of the movable body. Thus, a simple and reliable structure based on a flexible membrane element for interconnecting the fixable base body and the movable body can be provided.

Preferably, the membrane element extends from an inner circumferential region of the fixable base body to an outer circumferential region of the movable body. Thus, the membrane element allows for a secure sealing of the fluid chamber from below the fluid chamber.

Preferably, the membrane element is fixed to the fixable base body in an outer circumferential region of the membrane element. Further, the membrane element is fixed to the movable body in an inner circumferential region of the membrane element. Thus, a secure fixation of the membrane element both to the fixable base body and the movable body can be achieved.

Preferably, the membrane element is fixed to the fixable base body by means of a first plurality of fixing elements or by means of glue. Further, the membrane element is fixed to the movable body by means of a second plurality of fixing elements or by means of glue.

Preferably, the fluid-based cooling element further comprises a first support bracket for supporting the inner circumferential region of the membrane element, and a second support bracket for supporting the outer circumferential region of the membrane element. Thus, both the fixation of the membrane element and the sealing of the fluid chamber by means of the membrane element can be made even more secure.

For example, the membrane element has an accordion-like cross-sectional shape. Thus, it is possible to provide a flexible membrane element which allows for a reliable and flexible adjustment of the thermal and mechanical contact of the upper surface of the heat generating element.

For example, the deformable element is a rectangular-shaped sealing element arranged between an outer side surface of the movable body and an inner side surface of the fixable base body. Thus, a simple and reliable structure based on a flexible sealing element for interconnecting the fixable base body to the movable body and for securely sealing the fluid chamber from below the fluid chamber can be provided.

Preferably, the movable body has a circumferential recess defined in the outer side surface of the movable body. Further, the rectangular-shaped sealing element is received by the circumferential recess for slidably contacting the inner side surface of the fixable base body.

It is advantageous when the rectangular-shaped sealing element is configured for sealing the fluid chamber, such that a leakage of the cooling fluid received by the fluid chamber is prevented.

Preferably, the fluid-based cooling element further comprises a further plurality of stand-off members fixed to the movable body for fixing the movable body to the printed circuit board by means of a plurality of corresponding spring-loaded fixing elements.

Thus, it is possible to securely fix the movable body by applying a predefined pressure against the upper surface of the heat generating element.

The deformable element is made of a rubber material such as, for example, EPDM (ethylene propylene diene monomer (M-class)) rubber.

For example, the heat generating element may be a microprocessor, integrated circuit, or any other PCB component arranged on the printed circuit board, e.g. a memory IC (RAM), a non-volatile storage IC (flash storage), a bus line switch (PCle switch), an FPGA, an ASIC, an l/O-controller, a PHY controller, a coil, a diode, and a voltage converter.

According to an embodiment, a fluid-based cooling system comprises at least two of the previously described fluid-based cooling elements. Each of the at least two fluid-based cooling elements is configured for cooling an individual heat generating element arranged on the printed circuit board. The individual heat generating elements each have a predetermined height tolerance. The fluid-based cooling system is configured such that the individual heat generating elements each are cooled with a maximum cooling performance for each height of the respective individual heat generating elements, wherein said height is in a predetermined range defined by the predetermined height tolerance.

Further features and advantages of the invention result from the following description which explains the invention in more detail on the basis of embodiments in connection with the enclosed schematic figures:
- Figure 1A: shows a bottom perspective view of a first embodiment of a fluid-based cooling element for cooling a heat generating element arranged on a printed circuit board;
- Figure 1B: shows a top view of the first embodiment of the fluid-based cooling element according to Figure 1A, in which a fluid inlet and fluid outlet are omitted;
- Figure 1C: shows a sectional side view of the first embodiment of the fluid-based cooling element according to Figure 1A taken along line A-A in Figure 1B;
- Figure 1D: shows an exploded view of an assembly of the first embodiment of the fluid-based cooling element according to Figure 1A in a bottom perspective view;
- Figure 2A: shows a bottom perspective view of a second embodiment of a fluid-based cooling element for cooling a heat generating element arranged on a printed circuit board;
- Figure 2B: shows a top view of the second embodiment of the fluid-based cooling element according to Figure 2A, in which a fluid inlet and fluid outlet are omitted;
- Figure 2C: shows a sectional side view of the second embodiment of the fluid-based cooling element according to Figure 2A taken along line A-A in Figure 2B;
- Figure 2D: shows an exploded view of an assembly of the second embodiment of the fluid-based cooling element according to Figure 2A in a bottom perspective view;
- Figure 3A: shows a bottom perspective view of a third embodiment of a fluid-based cooling element for cooling a heat generating element arranged on a printed circuit board;
- Figure 3B: shows a top view of the third embodiment of the fluid-based cooling element according to Figure 3A, in which a fluid inlet and fluid outlet are omitted;
- Figure 3C: shows a sectional side view of the third embodiment of the fluid-based cooling element according to Figure 3A taken along line A-A in Figure 3B;
- Figure 3D: shows an exploded view of an assembly of the third embodiment of the fluid-based cooling element according to Figure 3A in a bottom perspective view;
- Figure 4A: shows a top view of the first or second embodiment of the fluid-based cooling element according to Figure 1A or 2A, in which a fluid inlet and fluid outlet as well as the sealing body are omitted;
- Figure 4B: shows a top view of the third embodiment of the fluid-based cooling element according to Figure 3A, in which a fluid inlet and fluid outlet as well as the sealing body are omitted;
- Figure 5A: shows a bottom perspective view of an embodiment of a fluid-based cooling system comprising two fluid-based cooling elements according to a fourth embodiment;
- Figure 5B: shows a top view of the embodiment of the fluid-based cooling system according to Figure 5A, in which a fluid inlet and fluid outlet are omitted;
- Figure 5C: shows a sectional side view of the embodiment of the fluid-based cooling system according to Figure 5A taken along line A-A in Figure 5B;
- Figure 5D: shows an exploded view of an assembly of the embodiment of the fluid-based cooling system according to Figure 5A in a bottom perspective view;
- Figure 5E: shows an exploded view of an assembly of the embodiment of the fluid-based cooling system according to Figure 5a in a top perspective view; and
- Figure 5F: shows a sectional side view of the embodiment of the fluid-cooling system according to Figure 5A taken along line A-A in Figure 5B together with a printed circuit board, in which the embodiment of the fluid-based cooling system is fixed to the printed circuit board.

Before discussing the invention in detail below referring to the figures, it is pointed out that in the embodiments illustrated below same elements or functionally equal elements are provided with the same reference numerals in the figures. A description of elements of equal reference numerals consequently is mutually exchangeable and/or mutually applicable in the different embodiments.

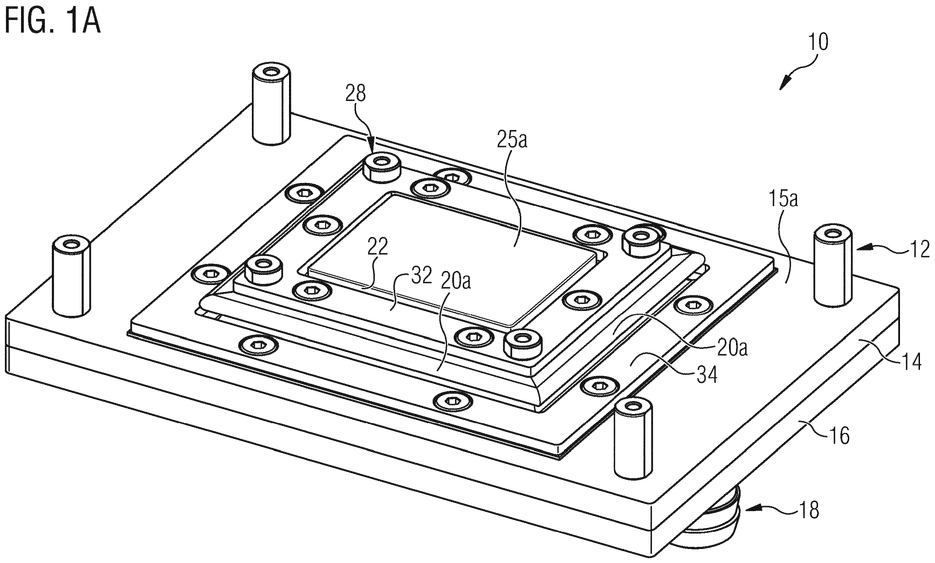

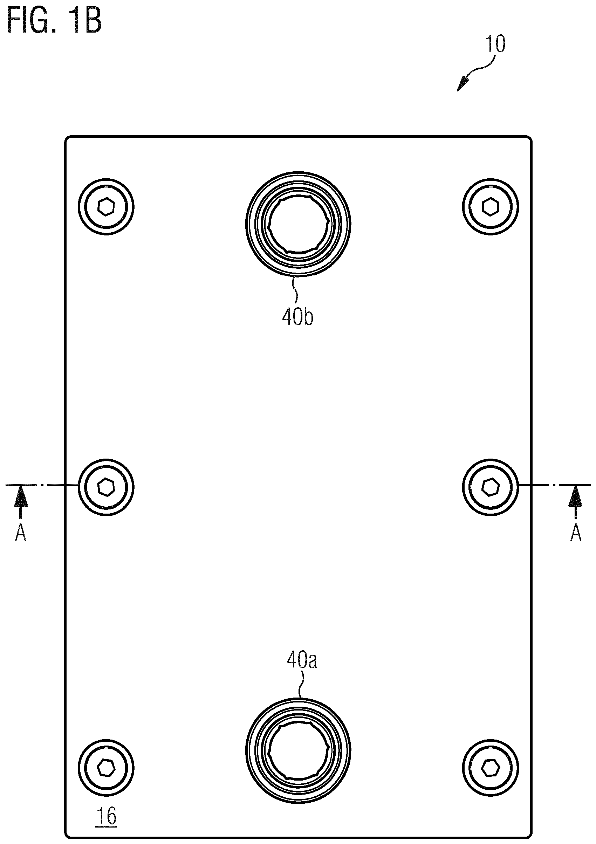

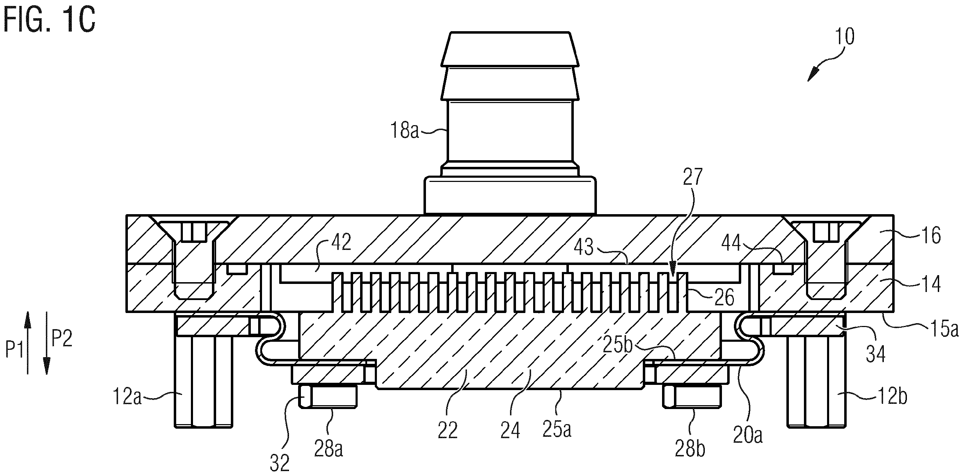

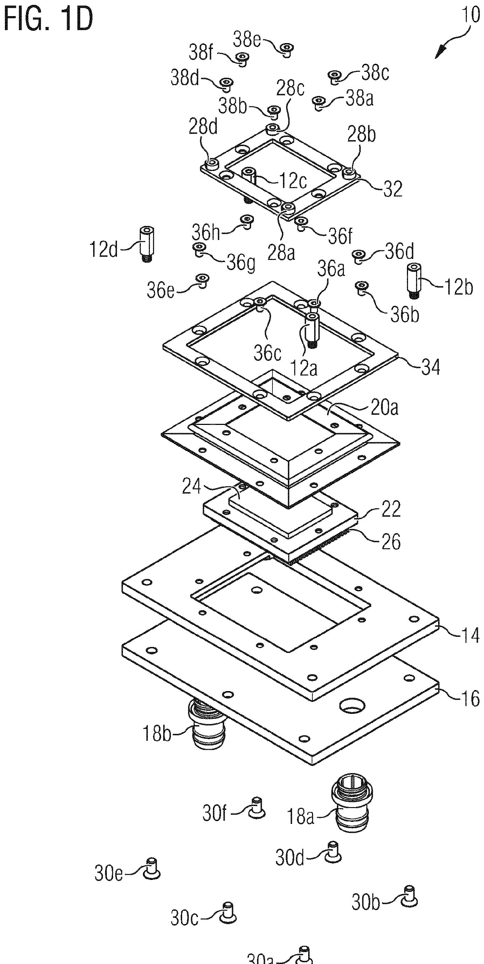

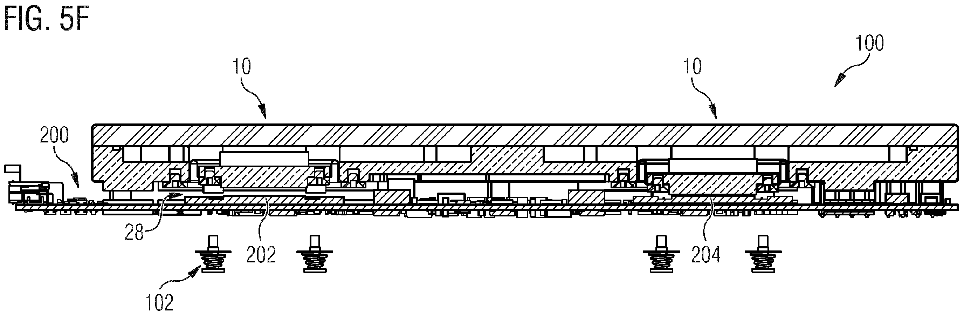

Figure 1A shows a bottom perspective view of a first embodiment of a fluid-based cooling element 10 for cooling a heat generating element arranged on a printed circuit board (e.g. the printed circuit board 200 exemplarily shown in Figure 5F). Figure 1B shows a top view of the first embodiment of the fluid-based cooling element 10 according to Figure 1A, in which a fluid inlet and fluid outlet 18 are omitted. Figure 1C shows a sectional side view of the first embodiment of the fluid-based cooling element 10 according to Figure 1A taken along line A-A in Figure 1B. Figure 1D shows an exploded view of an assembly of the first embodiment of the fluid-based cooling element 10 according to Figure 1A in a bottom perspective view. The first embodiment of the fluid-based cooling element 10 shown in Figures 1A to 1D comprises a fluid chamber 42 for receiving a cooling fluid, a movable body 22, and a deformable element 20a. As shown in Figure 1C, the movable body 22 is in fluidic contact with the fluid chamber 42 on an upper side of the movable body 22. The movable body 22 has a base portion 24 having a first lower surface 25a facing away from the fluid chamber 42. As further shown in Figure 1C, the deformable element 20a is in contact with the movable body 22 for movably supporting the movable body 22, such that the movable body 22 is movable towards or away from the fluid chamber 42 in a direction P1, P2 perpendicular to an inner upper surface 43 of the fluid chamber 42. Thereby, the position of the first lower surface 25a of the base portion 24 of the movable body 22 is adjustable in dependence on a variable height of the heat generating element arranged on the printed circuit board. This allows to achieve a maximum cooling performance for each height of the heat generating element within a predetermined range defined by a predetermined height tolerance.

In Figure 1C, the direction P1 is indicated by an arrow pointing towards the inner upper surface 43 of the fluid chamber 42, while the direction P2 is pointing away from the inner upper surface 43 of the fluid chamber 42. Further, the structure of the fluid-based cooling element 10 shown in Figure 1C has a horizontal position/orientation corresponding to a fixed state in which the fluid-based cooling element 10 is fixed above the printed circuit board having a base or reference horizontal position/orientation (see also Figure 5F).

As shown in Figure 1C, the movable body 22 has an upper portion 26 comprising a plurality of fins 27. The fins 27 of the upper portion 26 of the movable body 22 extend into the fluid chamber 42. Between the fins 27, a plurality of fluid channels are formed. The fluid chamber 42 is fluidically connected to a fluid inlet 18a and a fluid outlet 18b. In Figure 1C only the fluid inlet 18a is visible. In particular, the fluid chamber 42 is fluidically connected to the fluid inlet and fluid outlet 18 arranged above the fluid chamber 42 and is in fluidic contact with the movable body 22 arranged below the fluid chamber 42. The cooling fluid received by the fluid chamber 42 may be input by means of the fluid inlet 18a and output by means of the fluid outlet 18b. Further, the cooling fluid may flow through the plurality of fluid channels formed between the fins 27 of the upper portion 26 of the movable body 22 in a direction parallel to the inner upper surface 43 of the fluid chamber 42. By means of this fluid flow, the heat generating element arranged on the printed circuit board and being in contact with the first lower surface 25a of the base portion 24 of the movable body 22 can efficiently be cooled.

The structure of the first embodiment of the fluid-based cooling element 10 is now further illustrated with reference to Figures 1A to 1D. The first embodiment of the fluid-based cooling element 10 further comprises a plurality of standoff members 12a to 12b, a fixable base body 14 (which may also be referred to as main heatsink body), and a sealing body 16 (which may also be referred to as sealing lid). As shown in Figure 1A, the standoff members 12 are fixed to the fixable base body 14. The plurality of standoff members 12a to 12b serve for fixing the fluid-based cooling element 10 to the printed circuit board. As shown in Figures 1A and 1C, the sealing body 16 is fixed on top of the fixable base body 14. Referring to Figure 1C, the sealing body 16 has a lower surface defining the inner upper surface 43 of the fluid chamber 42. Between the fixable base body 14 and the sealing body 16, a circumferential sealing element (i.e. a sealing gasket 44) is arranged. Further referring to Figure 1C, the fluid chamber 42 is sealed from below by means of the deformable element 20a. The deformable element 20a serves for connecting the movable body 22 (which may also be referred to as inner pedestal heatsink body) to the fixable base body 14. In particular, the fixable base body 14, the sealing body 16, the movable body 22 and the deformable element 20a together define the fluid chamber 42.

The first embodiment of the fluid-based cooling element 10 comprises a membrane element (e.g. a rubber gasket) having an accordion-like cross-sectional shape serving as the deformable element 20a. The specific shape of the membrane element 20a (which has an upper and a lower arch-shaped portion being arranged on top of each other) is clearly visible in Figure 1C. The membrane element 20a extends from the lower surface 15a of the fixable base body 14 to a second lower surface 25b of the base portion 24 of the movable body 22. As shown in Figure 1C, the second lower surface 25b is recessed from the plane defined by the position of the first lower surface 25a of the base portion 24 of the movable body 22. In particular, the membrane element 20a flexible supports the movable body 22 from below and in an outer circumferential region of the movable body 22.

Due to the accordion-like cross-sectional shape of the membrane element 20a, the membrane element 20a can be flexibly bent, such that the movable body 22 will be freely moved with respect to the fixable base body 14 in the direction P1 or P2. Thereby, the position of the first lower surface 25a of the base portion 24 of the movable body 22 can be adjustably displaced relative to the position of the lower surface 15a of the fixable base portion 14. In particular, the position of the first lower surface 25a or the position of the lower surface 15a may be defined with respect to the plane defined by the lower end of the fluid-based cooling element 10 where it is fixable to the printed circuit board.

As shown in Figure 1A, the membrane element 20a extends from an inner circumferential region of the fixable base body 14 to an outer circumferential region of the movable body 22. As further shown in Figure 1A, the membrane element 20a is fixed to the fixable base body 14 in an outer circumferential region of the membrane element 20a, while the membrane element 20a is fixed to the movable body 22 in an inner circumferential region of the membrane element 20a. The membrane element 20a has, in a bottom view, an inner and outer rectangular-shaped perimeter.

The assembly of the first embodiment of the fluid-based cooling element 10 shown in Figure 1D comprises a first and a second plurality of fixing elements 36a-36h, 38a-38f. The assembly shown in Figure 1D further comprises a first and a second support bracket 32, 34. The first support bracket 32 serves for supporting the inner circumferential region of the membrane element 20a, while the second support bracket 34 serves for supporting the outer circumferential region of the membrane element 20a. The first and the second support bracket 32, 34 are adapted to the size of the inner and outer circumferential region of the membrane element 20a. By means of the first plurality of fixing elements 36a-36h, the membrane element 20a is fixed to the fixable base body 14 in the outer circumferential region of the membrane element 20a, while by means of the second plurality of fixing elements 38a-38f, the membrane element 20a is fixed to the movable body 22 in the inner circumferential region of the membrane element 20a. The resulting fixed state of the membrane element 20a is clearly shown in Figure 1A.

Referring again to Figure 1D, a third plurality of fixing elements 30a-30f may be used to fix the sealing body 16 to the fixable base body 14. Figure 1D also shows the fluid inlet 18a and fluid outlet 18b which may be received by corresponding fluid openings extending through the sealing body 16. These fluid openings are denoted by reference numerals 40a, 40b and are clearly shown in Figure 1B.

In Figure 1D there are also shown a further plurality of standoff members 28a to 28d which may be fixed to the movable body 22 in the inner circumferential region of the membrane element 20a. The fixed stage of these standoff members 28 is depicted in Figure 1A. The plurality of standoff members 28a-28d serve for fixing the movable body 22 to the printed circuit board. In particular, the plurality of standoff members 28a-28d each comprise a thread for receiving a corresponding spring-loaded fixing elemen. By means of the plurality of spring-loaded fixing elements (e.g. the spring-loaded fixing elements 102 exemplarily shown in Figure 5F), the movable body 22 can be securely fixed to the printed circuit board while exerting a predefined pressure against the heat generating element arranged thereon. With reference to Figure 1C, the outer standoff members 12 provide a fixed height of the fixable base body 14, while the inner standoff members 28 provide a variable height of the movable body 22 with respect to a plane defined by the lower end of the outer standoff members 12 to be fixed to the printed circuit board.

In other words, special screws (spring-loaded) may be used for securing the pedestal heatsink body with a specific pressure to the heat generating integrated circuit (normally a processor), independently of the main heatsink body, which is fastened to the printed circuit board by using regular screws to be screwed into the longer standoffs. Shorter standoffs on the pedestal heatsink body substantially provide the thread for the spring-loaded screws to be screwed into the same. The length of the spring-loaded screws limits the compressibility of the springs.

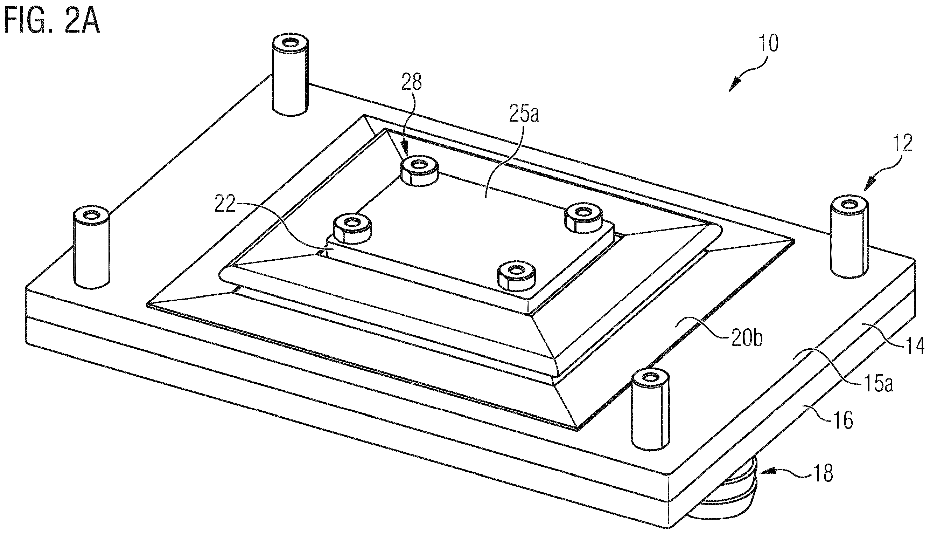

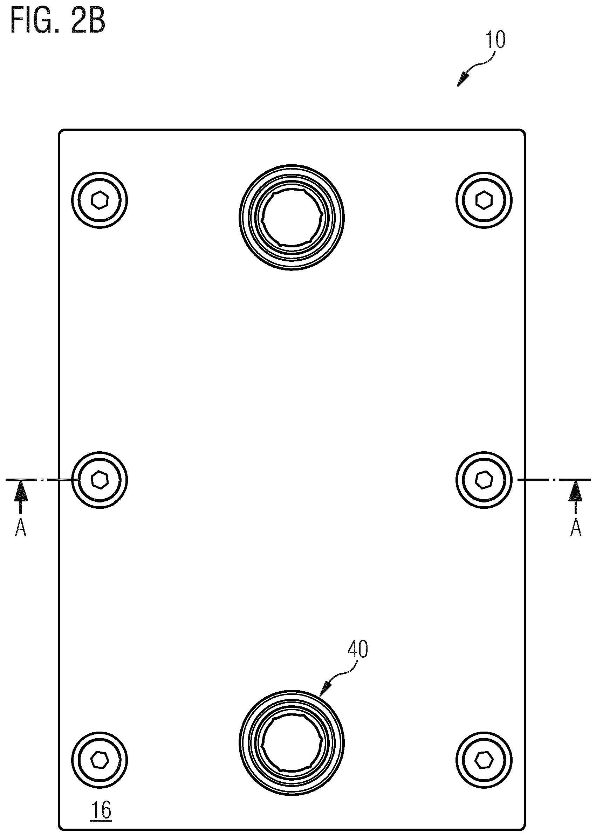

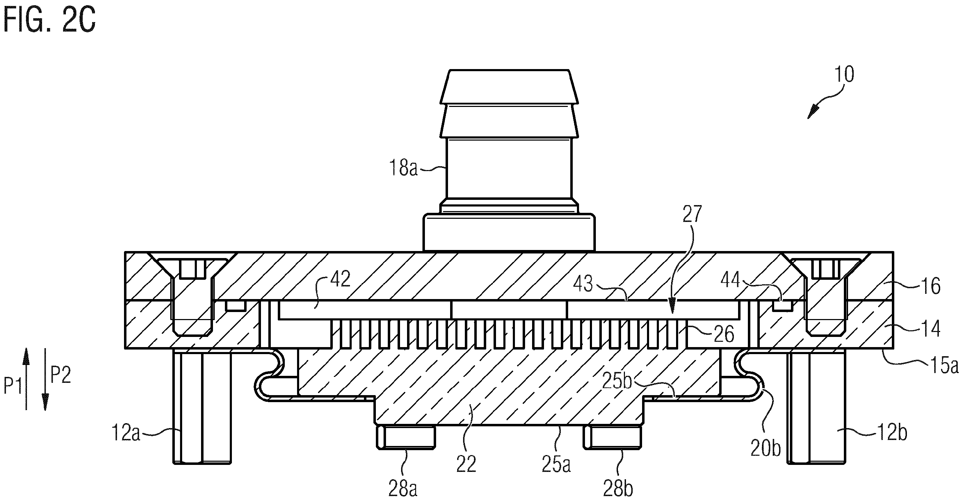

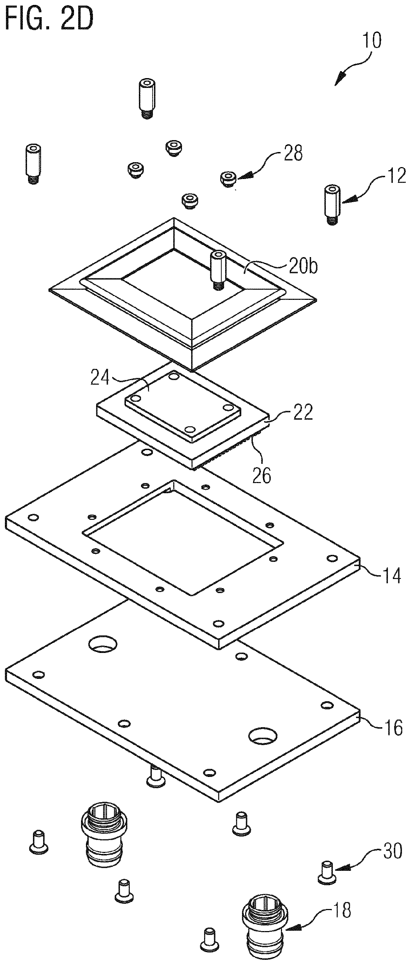

Figure 2A shows a bottom perspective view of a second embodiment of a fluid-based cooling element 10 for cooling a heat generating element arranged on a printed circuit board. Figure 2B shows a top view of the second embodiment of the fluid-based cooling element 10 according to Figure 2A, in which the fluid inlet 18a and fluid outlet 18b are omitted. Figure 2C shows a sectional side view of the second embodiment of the fluid-based cooling element 10 according to Figure 2A taken along line A-A in Figure 2B. Figure 2D shows an exploded view of an assembly of the second embodiment of the fluid-based cooling element 10 according to Figure 2A in a bottom perspective view. The second embodiment of the fluid-based cooling element 10 shown in Figures 2A to 2D substantially corresponds to the first embodiment of the fluid-based cooling element 10 shown in Figures 1A to 1D having the same or similar elements denoted by the same reference numerals. However, the second embodiment of the fluid-based cooling element 10 shown in Figures 2A to 2D comprises a membrane element 20b which does not have fixing holes. Instead, the membrane element 20b is fixed to the fixable base body 14 by means of glue, and is also fixed to the movable body 22 by means of glue. Accordingly, the membrane element 20b can be fixed to the fixable base body 14 and the movable body 22 in an alternative way.

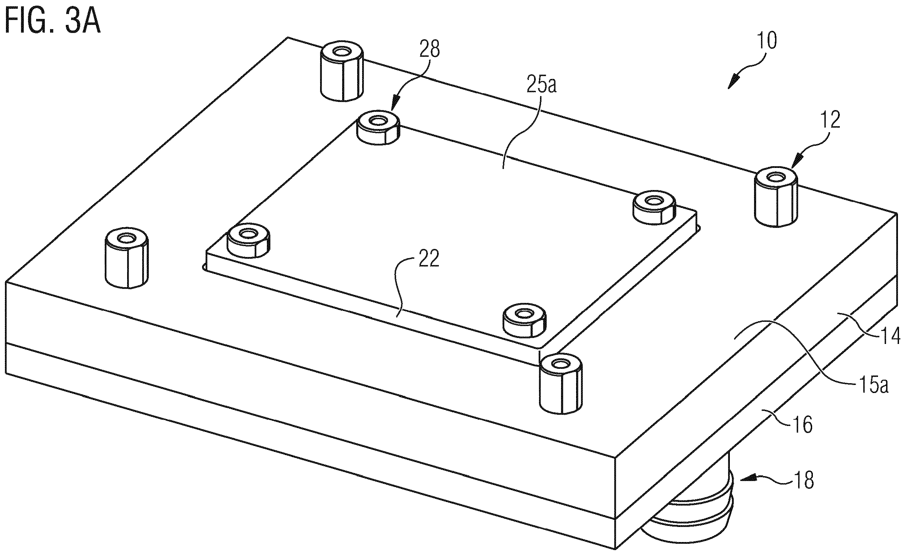

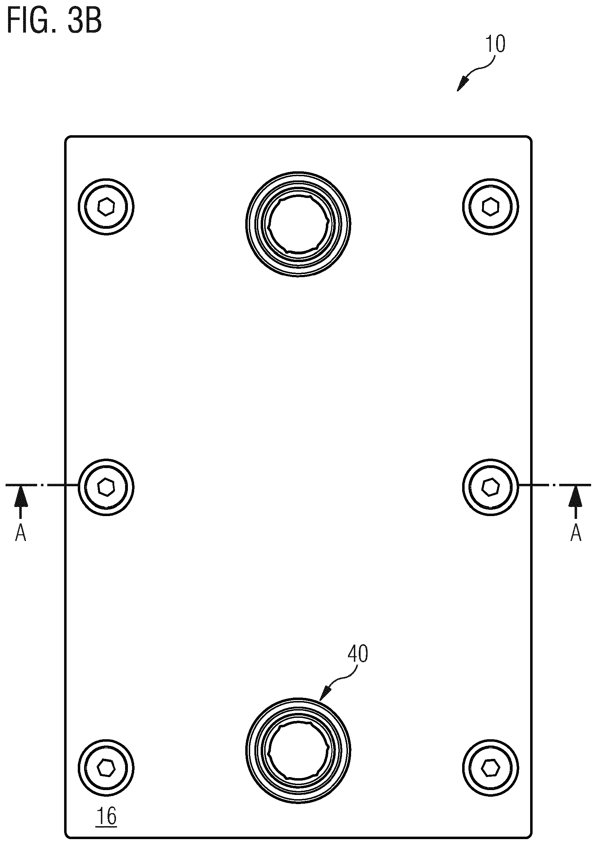

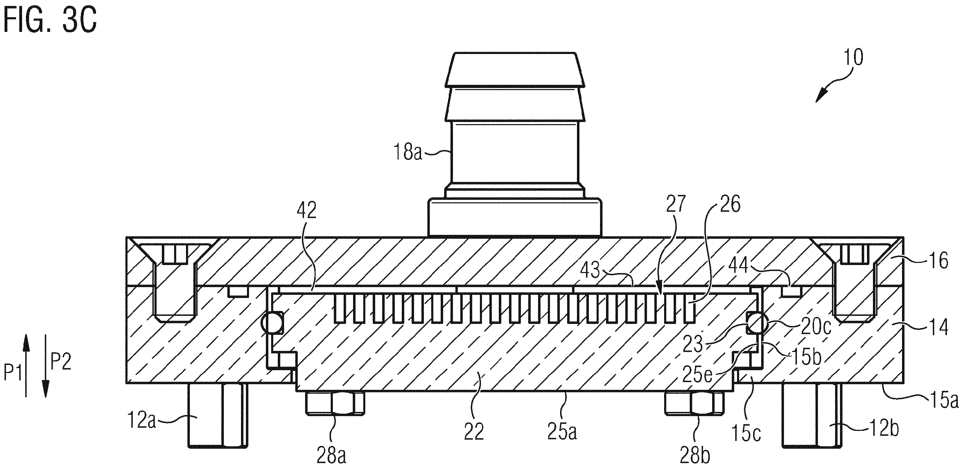

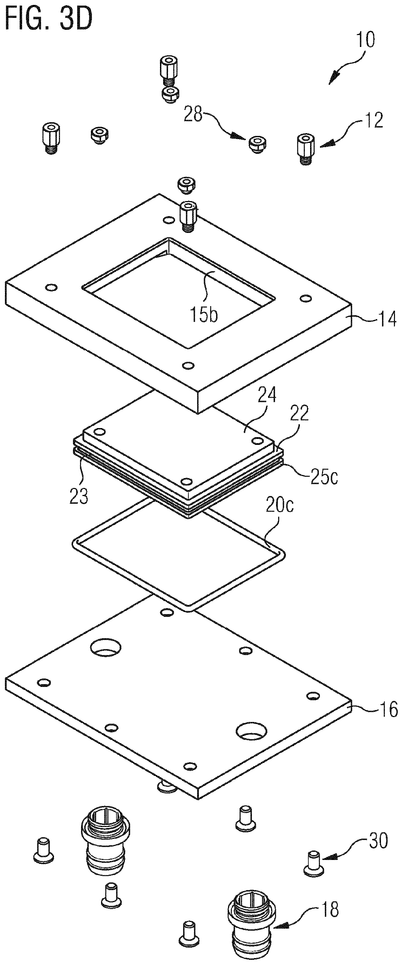

Figure 3A shows a bottom perspective view of a third embodiment of a fluid-based cooling element 10 for cooling a heat generating element arranged on a printed circuit board. Figure 3B shows a top view of the third embodiment of the fluid-based cooling element 10 according to Figure 3A, in which the fluid inlet 18a and fluid outlet 18b are omitted. Figure 3C shows a sectional side view of the third embodiment of the fluid-based cooling element 10 according to Figure 3A taken along a line A-A in Figure 3B. Figure 3D shows an exploded view of an assembly of the third embodiment of the fluid-based cooling element 10 according to Figure 3A in a bottom perspective view. The third embodiment of the fluid-based cooling element 10 shown in Figures 3A to 3D substantially corresponds to the first embodiment of the fluid-based cooling element 10 shown in Figures 1A to 1D having the same or similar elements denoted by the same reference numerals. However, the third embodiment of the fluid-based cooling element 10 shown in Figures 3A to 3D comprises a rectangular-shaped sealing element 20c, for example, a rubber gasket, as the deformable element (cf. in particular Figure 3D). Referring to Figure 3C, the rectangular-shaped sealing element 20c is arranged between an outer side surface 25c of the movable body 22 and an inner side surface 15b of the fixable base body 14. Further referring to Figures 3C and 3D, the movable body 22 has a circumferential recess 23 defined in the outer side surface 25c of the movable body 22. The circumferential recess 23 serves for receiving the rectangular-shaped sealing element 20c, such that the inner side surface 15b of the fixable base body 14 will be slidably contacted by the sealing element 20c. By slidably contacting the inner side surface 15b of the fixable base body 14, the sealing element 20c provides for a flexible adjustment of the movable body 22 in the direction P1 or P2. When the movable body 22 is moved in the direction P1, its movement will be limited by the inner upper surface 43 of the fluid chamber 42. On the other hand, when the movable body 22 is moved in the direction P2, its movement will be limited by a protrusion 15c at the lower inner end of the fixable base body 14. By using the rectangular-shaped sealing element 20c, the fluid chamber 42 can be securely sealed. This substantially prevents a leakage of the cooling fluid from the fluid chamber 42.

In other words, the third embodiment of the fluid-based cooling element 10 allows adjusting the height (position) of the pedestal heatsink body. The gasket 20c preferably has a function of providing a liquid and gas seal so that the cooling medium (coolant) cannot escape/leak. The maximum offset is limited by the shape of the pedestal heatsink body on one side and the sealing lid on the other side.

As an alternative to the structure of Figure 3C, the circumferential recess may not be defined in the outer side surface 25c of the movable body 22, but in the inner side surface 15b of the fixable base body 14. In this case, the sealing element 20c will be received by the circumferential recess for slidably contacting the outer side surface 25c of the movable body 22.

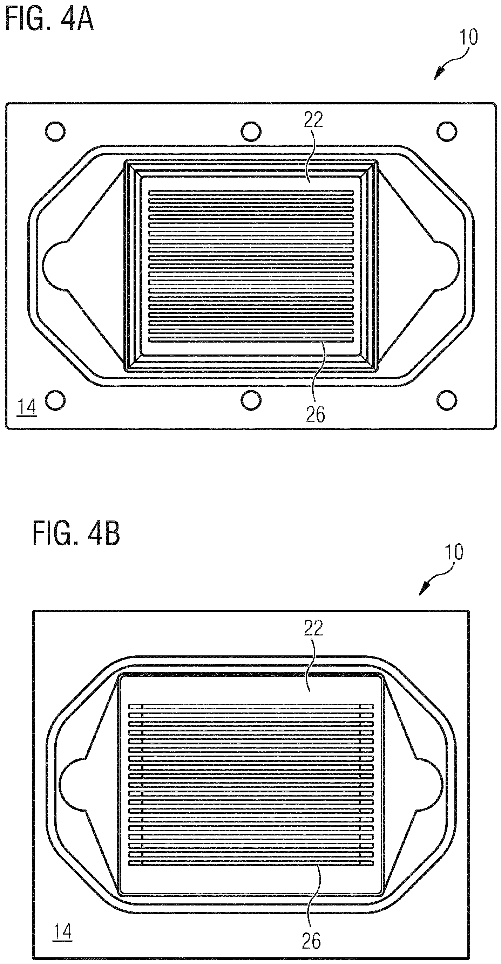

Figure 4A shows a top view of the first or second embodiment of the fluid-based cooling element 10 according to Figure 1A or 2A, in which the fluid inlet and fluid outlet 18 as well as the sealing body 16 are omitted. Figure 4B shows a top view of the third embodiment of the fluid-based cooling element 10 according to Figure 3A, in which the fluid inlet and fluid outlet 18 as well as the sealing body 16 are omitted. In Figures 4A and 4B, the structure of the upper portion 26 of the movable body 22 forming the fluid channels are clearly visible.

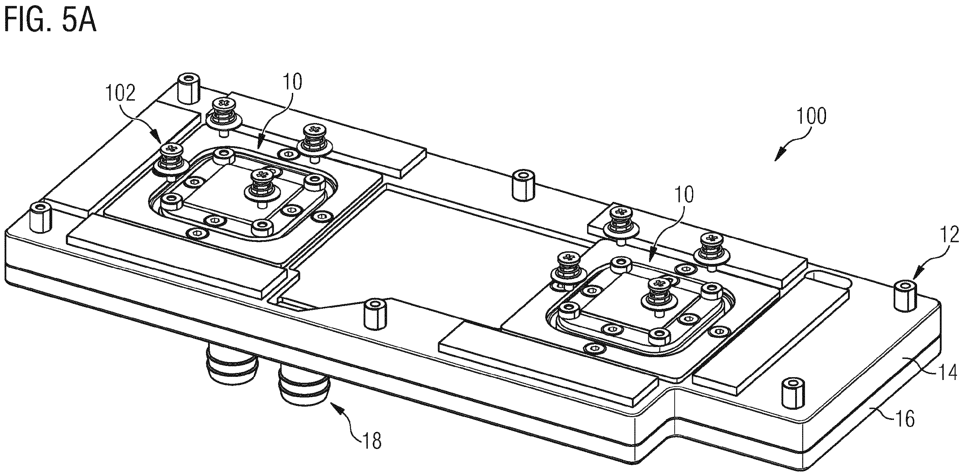

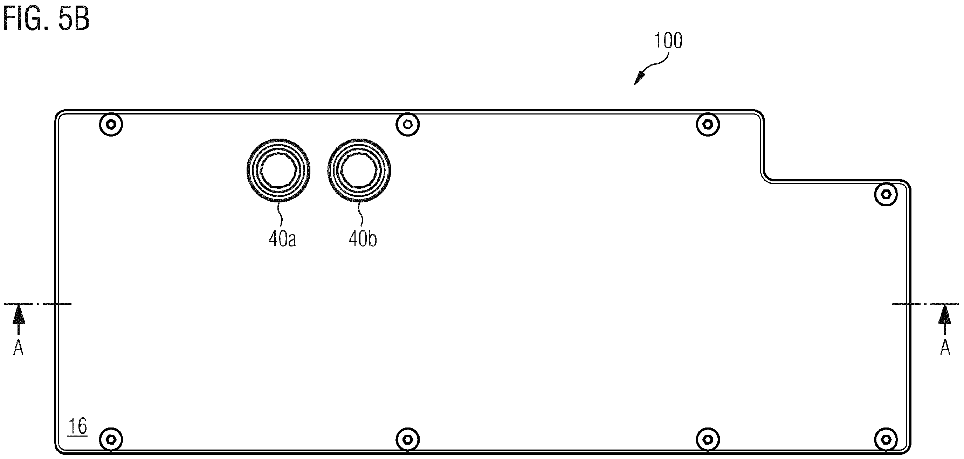

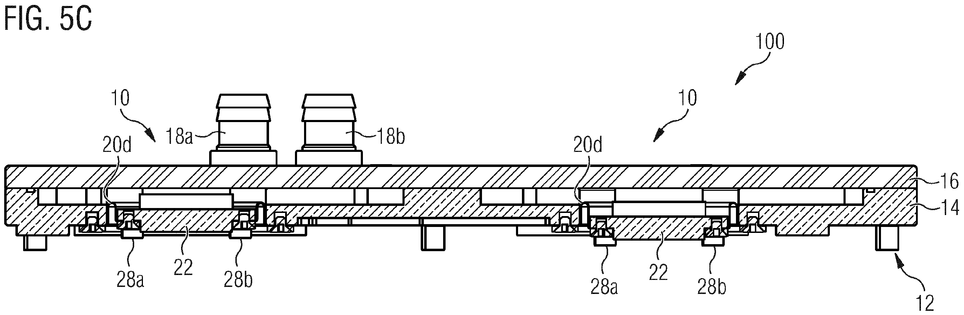

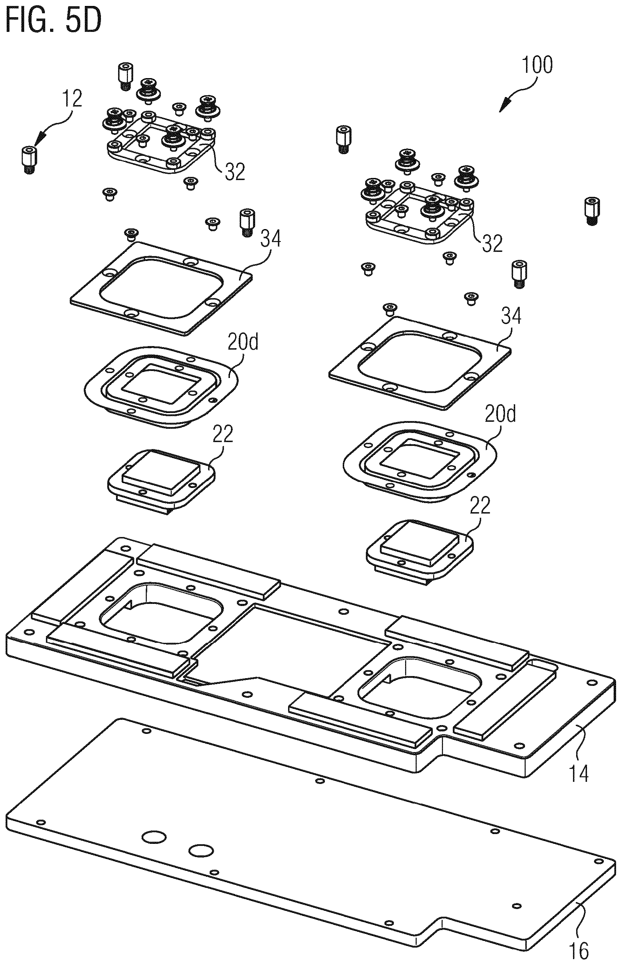

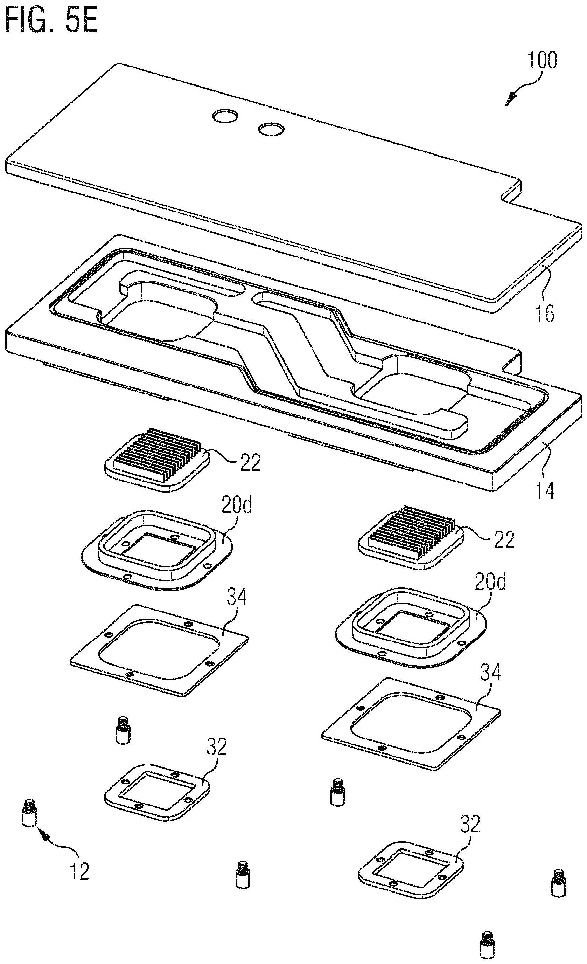

Figure 5A shows a bottom perspective view of an embodiment of a fluid-based cooling system 100 comprising two fluid-based cooling elements 10 according to a fourth embodiment. Figure 5B shows a top view of the embodiment of the fluid-based cooling system 100 according to Figure 5A, in which a fluid inlet and fluid outlet 18 are omitted. Figure 5C shows a sectional side view of the embodiment of the fluid-based cooling system 100 according to Figure 5A taken along line A-A in Figure 5B. Figure 5D shows an exploded view of an assembly of the embodiment of the fluid-based cooling system 100 according to Figure 5A in a bottom perspective view. Figure 5E shows an exploded view of an assembly of the embodiment of the fluid-based cooling system 100 according to Figure 5a in a top perspective view. Figure 5F shows a sectional side view of the embodiment of the fluid-cooling system 100 according to Figure 5A taken along line A-A in Figure 5B together with a printed circuit board 200, in which the embodiment of the fluid-based cooling system 100 is fixed to the printed circuit board 200. The fluid-based cooling elements 10 according to the fourth embodiment substantially correspond to the first embodiment of the fluid-based cooling element 10.

As shown in Figure 5A, the embodiment of the fluid-based cooling system 100 comprises the two fluid-based cooling elements 10 arranged adjacent to each other within a common fixable base body 14. As further shown in Figure 5C, the movable bodies 22 of the two fluid-based cooling elements 10 each are in fluidic contact with corresponding fluid chambers arranged above the respective movable bodies 22. Referring to Figure 5E, both fluid chambers are fluidically interconnected by a fluid path formed within the common fixable base body 14. This fluid path, in turn, is fluidically connected to the fluid inlet 18a and fluid outlet 18b shown in Figure 5C.

In Figure 5F, the fixed state of the fluid-based cooling system 100 is depicted. In this fixed state, each of the two fluid-based cooling elements 10 serve for cooling an individual heat generating element 202, 204 arranged on the printed circuit board 200. The individual heat generating elements 202, 204 may each have a predetermined height tolerance. By means of the embodiment of the fluid-based cooling system 100, the individual heating generating elements 202, 204 each can be efficiently cooled with a maximum cooling performance. This is in particular possible for each height of the respective individual heat generating elements being in a predetermined range defined by the predetermined height tolerance.

In other words, the embodiment of the fluid-based cooling system 100 comprises two separate pedestal heatsink bodies within a main heatsink body. Such an embodiment may be useful if the heatsink needs to be applied to a PCB assembly with two different IC (integrated circuits) or processors with different stack-up tolerances. For example, a processor of type A has a stack-up tolerance of +/- 0.15 mm, while a processor of type B has a stack-up tolerance of +/-0.3 mm. Both processors A and B each are a high power chip and thus require maximum cooling. In a known worst case scenario, processor B would not have good enough of a mechanical contact with the pedestal heatsink body. In addition, a thermal pad could not be used in this case because the thermal performance would be inadequate. Hence, contrary to the prior art, the embodiment of the fluid-based cooling system 100 provides for two (or more) separate independently adjustable pedestal heatsink bodies within a main heatsink body to overcome the above-mentioned disadvantage.

Preferably, a compressible TIM layer (e.g. a TIM putty) is provided between the main heatsink body and the printed circuit board 200 in the fixing region of the fluid-based cooling system 100. Further, a thin non-compressible layer (e.g. a TIM paste) may be provided on top of the respective heat generating elements 202, 204 in the contacting region of the pedestal heatsink bodies.

Preferably, the deformable element 20a-20d of any of the first to third embodiment is made of a rubber or rubber-like material. For example, an EPDM rubber may be used. Needless to say that the afore-mentioned materials are only to be taken as examples. Thus, the deformable element 20a-20d may also been made from non-plastic and non-rubber materials, e.g. metal materials such as thin-sheet aluminum, stainless steel or copper.

It is advantageous when the cooling fluid is a cooling liquid allowing for a relatively high heat capacity.

According to embodiments, the cooling element 10, such as within the cooling system 100, may be divided into two or more sections (i.e. the fixable base body 14 and the movable body 22) which are interconnected by an accordion-like rubber membrane 20a and sealing frames 32, 34. Such a structure allows for a flexible adjustment to a single or two or more types of PCB elements/components with a given or different levels of package height tolerances. High-power chips (e.g. a GPU or a CPU) which require a direct contact with the cooling elements and which tend to have the largest deviation tolerance level, may thus nevertheless have an ideal contact, regardless of the height tolerances of the same or other PCB elements. Spacers (i.e. standoff members 12 and 28) which are fixed to the separate sections ensure a steady contact pressure even in case of cooling of nonlinear PCB elements, because the loose (flexible) connection between the multiple sections of the cooling element 10 allows the latter to adjust to the PCB elements and not vice versa. Thus, embodiments provide a cooling element 10 that is capable of adapting to the components of the PCB and not vice versa. Further, embodiments enable an optimal thermal and mechanical contact with all of the selected items (i.e. the PCB elements to be cooled).

Embodiments provide a cooling element 10 with a variable height of the contact surface 25a by means of a pedestal body 22 for a circular cooling with single and multiphase cooling fluids.

Embodiments provide a high reliability and a maximum cooling performance of the cooling process. Further, embodiments allow to avoid a difficulty which arises from the typical nonlinear assembling of the PCB components. Because of the very nature of producing PCBs with such components, certain elements are not soldered perfectly parallel to the base PCB or are not sealed completely parallel to the intermediate layer. However, by the use of the embodiments, it is possible to avoid that this will result in an excessive force on the upper edge of the elements and potentially in a physical breakage thereof, as well as in sub-optimal thermal contact. Thus, embodiments may overcome the difficulties resulting from a bending of the PCB, while providing an optimal mechanical and thermal contact with the selected elements and even an operation outside the tolerance specifications.

Embodiments may be applied to the cooling of microprocessors, integrated circuits, and other components on a printed circuit of a PCB card.

### List of reference signs

- 10: fluid-based cooling element
- 12, 28: standoff members
- 14: fixable base body
- 16: sealing body
- 18: fluid inlet/outlet
- 20a-20d: deformable element
- 22: movable body
- 23: recess
- 24: base portion
- 26: upper portion
- 27: fins
- 30, 36, 38, 102: fixing elements
- 32, 34: support bracket
- 40: fluid opening
- 42: fluid chamber
- 44: sealing element
- 100: fluid-based cooling system
- 200: printed circuit board
- 202, 204: heat generating element
- P1, P2: direction

## Claims

1. A fluid-based cooling element (10) for cooling a heat generating element (202, 204) arranged on a printed circuit board (PCB) (200), wherein the fluid-based cooling element (10) comprises:
a fluid chamber (42) for receiving a cooling fluid; and
a movable body (22) being in fluidic contact with the fluid chamber (42) on an upper side of the movable body (22), wherein the movable body (22) has a base portion (24) having a first lower surface (25a) facing away from the fluid chamber (42);
**characterized in that** the first lower surface (25a) of the base portion (24) of the movable body (22) is configured to be in contact with the heat generating element (202, 204) arranged on the printed circuit board (200),
wherein a deformable element (20a; 20b; 20c; 20d) is in contact with the movable body (22) for movably supporting the movable body (22), such that the movable body (22) is movable towards or away from the fluid chamber (42) in a direction (P1, P2) perpendicular to an inner upper surface (43) of the fluid chamber (42), such that the position of the first lower surface (25a) of the base portion (24) of the movable body (22) being in contact with the heat generating element (202, 204) arranged on the printed circuit board (200) is adjustable in dependence on a variable height of the heat generating element (202, 204) arranged on the printed circuit board (200), and
wherein the deformable element (20a; 20b; 20c; 20d) is made of a rubber material.

2. The fluid-based cooling element (10) according to claim 1, further comprising a plurality of standoff members (12a-12d) for fixing the fluid-based cooling element (10) to the printed circuit board (200), a fixable base body (14), wherein the plurality of standoff members (12a-12d) are fixed to the fixable base body (14), and a sealing body (16) fixed on top of the fixable base body (14), wherein the sealing body (16) has a lower surface defining the inner upper surface (43) of the fluid chamber (42), wherein the deformable element (20a; 20b; 20c; 20d) is configured for connecting the movable body (22) to the fixable base body (14), and wherein the fixable base body (14), the sealing body (16), the movable body (22) and the deformable element (20a; 20b; 20c; 20d) together define the fluid chamber (42).

3. The fluid-based cooling element (10) according to claim 2, wherein the deformable element (20a; 20b; 20c; 20d) is configured to freely move the movable body (22) with respect to the fixable base body (14) in a direction (P1, P2) perpendicular to a lower surface (15a) of the fixable base body (14), such that the position of the first lower surface (25a) of the base portion (24) of the movable body (22) is displaced with respect to the position of the lower surface (15a) of the fixable base body (14).

4. The fluid-based cooling element (10) according to claim 2 or 3, wherein the deformable element (20a; 20b; 20c; 20d) is a membrane element (20a; 20b) extending from the lower surface (15a) of the fixable base body (14) to a second lower surface (25b) of the base portion (24) of the movable body (22), wherein the second lower surface (25b) is recessed from the plane defined by the position of the first lower surface (25a) of the base portion (24) of the movable body (22).

5. The fluid-based cooling element (10) according to claim 4, wherein the membrane element (20a; 20b) extends from an inner circumferential region of the fixable base body (14) to an outer circumferential region of the movable body (22).

6. The fluid-based cooling element (10) according to claim 4 or 5, wherein the membrane element (20a; 20b) is fixed to the fixable base body (14) in an outer circumferential region of the membrane element (20a; 20b), and wherein the membrane element (20a; 20b) is fixed to the movable body (22) in an inner circumferential region of the membrane element (20a; 20b).

7. The fluid-based cooling element (10) according to one of the claims 4 to 6, wherein the membrane element (20a; 20b) is fixed to the fixable base body (14) by means of a first plurality of fixing elements (36a-36h) or by means of glue, and wherein the membrane element (20a; 20b) is fixed to the movable body (22) by means of a second plurality of fixing elements (38a-38f) or by means of glue.

8. The fluid-based cooling element (10) according to one of the claims 4 to 7, further comprising a first support bracket (32) for supporting the inner circumferential region of the membrane element (20a), and a second support bracket (34) for supporting the outer circumferential region of the membrane element (20a).

9. The fluid-based cooling element (10) according to one of the claims 4 to 8, wherein the membrane element (20a; 20b) has an accordion-like cross-sectional shape.

10. The fluid-based cooling element (10) according to claim 2 or 3, wherein the deformable element (20a; 20b; 20d; 20d) is a rectangular-shaped sealing element (20c) arranged between an outer side surface (25c) of the movable body (22) and an inner side surface (15b) of the fixable base body (14).

11. The fluid-based cooling element (10) according to claim 10, wherein the movable body (22) has a circumferential recess (23) defined in the outer side surface (25c) of the movable body (22), and wherein the rectangular-shaped sealing element (20c) is received by the circumferential recess (23) for slidably contacting the inner side surface (15b) of the fixable base body (14).

12. The fluid-based cooling element (10) according to claim 10 or 11, wherein the rectangular-shaped sealing element (20c) is configured for sealing the fluid chamber (42), such that a leakage of the cooling fluid received by the fluid chamber (42) is prevented.

13. The fluid-based cooling element (10) according to one of the claims 2 to 12, further comprising a further plurality of standoff members (28a-28d) fixed to the movable body (22) for fixing the movable body (22) to the printed circuit board (200) by means of a plurality of corresponding spring-loaded fixing elements (102).

14. A fluid-based cooling system (100) comprising at least two fluid-based cooling elements (10) according to one of the claims 1 to 13, wherein each of the at least two fluid-based cooling elements (10) is configured for cooling an individual heat generating element (202, 204) arranged on the printed circuit board (200), wherein the individual heat generating elements (202, 204) each have a predetermined height tolerance, and wherein the fluid-based cooling system (100) is configured such that the individual heat generating elements (202, 204) each are cooled with a maximum cooling performance for each height of the respective individual heat generating elements (202, 204), wherein said height is in a predetermined range defined by the predetermined height tolerance.

## Patentansprüche

1. Fluidbasiertes Kühlelement (10) zum Kühlen eines Wärmeerzeugungselements (202, 204), das auf einer Leiterplatte (PCB) (200) angeordnet ist, wobei das fluidbasierte Kühlelement (10) umfasst:
eine Fluidkammer (42) zum Aufnehmen eines Kühlfluids; und
einen beweglichen Körper (22), der auf einer oberen Seite des beweglichen Körpers (22) in Fluidkontakt mit der Fluidkammer (42) ist, wobei der bewegliche Körper (22) einen Basisabschnitt (24) hat, der eine erste untere Fläche (25a) hat, die von der Fluidkammer (42) abgewandt ist;
**dadurch gekennzeichnet, dass** die erste untere Fläche (25a) des Basisabschnitts (24) des beweglichen Körpers (22) so ausgebildet ist, dass sie in Kontakt mit dem Wärmeerzeugungselement (202, 204) ist, das auf der Leiterplatte (200) angeordnet ist,
wobei ein verformbares Element (20a; 20b; 20c; 20d) mit dem beweglichen Körper (22) in Kontakt ist, um den beweglichen Körper (22) derart beweglich zu stützen, dass der bewegliche Körper (22) hin zu oder weg von der Fluidkammer (42) in einer Richtung (P1, P2), die senkrecht zu einer inneren oberen Fläche (43) der Fluidkammer (42) ist, derart beweglich ist, dass die Position der ersten unteren Fläche (25a) des Basisabschnitts (24) des beweglichen Körpers (22), die in Kontakt mit dem auf der Leiterplatte (200) angeordneten Wärmeerzeugungselement (202, 204) ist, abhängig von einer veränderlichen Höhe des auf der Leiterplatte (200) angeordneten Wärmeerzeugungselements (202, 204) einstellbar ist, und
wobei das verformbare Element (20a; 20b; 20c; 20d) aus einem Gummimaterial hergestellt ist.

2. Fluidbasiertes Kühlelement (10) nach Anspruch 1, ferner umfassend eine Vielzahl von Abstandselementen (12a-12d) zum Befestigen des fluidbasierten Kühlelements (10) auf der Leiterplatte (200), einen befestigbaren Basiskörper (14), wobei die Vielzahl von Abstandselementen (12a - 12d) an dem befestigbaren Basiskörper (14) befestigt sind, und ein oben an dem befestigbaren Basiskörper (14) befestigter Dichtungskörper (16), wobei der Dichtungskörper (16) eine untere Fläche hat, die die innere obere Fläche (43) der Fluidkammer (42) definiert, wobei das verformbare Element (20a; 20b; 20c; 20d) ausgebildet ist, um den beweglichen Körper (22) mit dem befestigbaren Basiskörper (14) zu verbinden, und wobei der befestigbare Basiskörper (14), der Dichtungskörper (16), der bewegliche Körper (22) und das verformbare Element (20a; 20b; 20c; 20d) zusammen die Fluidkammer (42) definieren.

3. Fluidbasiertes Kühlelement (10) nach Anspruch 2, wobei das verformbare Element (20a; 20b; 20c; 20d) ausgebildet ist, um den beweglichen Körper (22) in Bezug auf den befestigbaren Basiskörper (14) in eine Richtung (P1, P2), die senkrecht zu einer unteren Fläche (15a) des befestigbaren Basiskörpers (14) ist, derart frei zu bewegen, dass die Position der ersten unteren Fläche (25a) des Basisabschnitts (24) des beweglichen Körpers (22) in Bezug auf die Position der unteren Fläche (15a) des befestigbaren Basiskörpers (14) verschoben wird.

4. Fluidbasiertes Kühlelement (10) nach Anspruch 2 oder 3, wobei das verformbare Element (20a; 20b; 20c; 20d) ein Membranelement (20a; 20b) ist, das sich von der unteren Fläche (15a) des befestigbaren Basiskörpers (14) zu einer zweiten unteren Fläche (25b) des Basisabschnitts (24) des beweglichen Körpers (22) erstreckt, wobei die zweite untere Fläche (25b) von der Ebene, die von der Position der ersten unteren Fläche (25a) des Basisabschnitts (24) des beweglichen Körpers (22) definiert ist, zurückversetzt ist.

5. Fluidbasiertes Kühlelement (10) nach Anspruch 4, wobei sich das Membranelement (20a; 20b) von einer inneren Umfangsregion des befestigbaren Basiskörpers (14) zu einer äußeren Umfangsregion des beweglichen Körpers (22) erstreckt.

6. Fluidbasiertes Kühlelement (10) nach Anspruch 4 oder 5, wobei das Membranelement (20a; 20b) an dem befestigbaren Basiskörper (14) in einer äußeren Umfangsregion des Membranelements (20a; 20b) befestigt ist und wobei das Membranelement (20a; 20b) an dem beweglichen Körper (22) in einer inneren Umfangsregion des Membranelements (20a; 20b) befestigt ist.

7. Fluidbasiertes Kühlelement (10) nach einem der Ansprüche 4 bis 6, wobei das Membranelement (20a; 20b) an dem befestigbaren Basiskörper (14) mittels einer ersten Vielzahl von Befestigungselementen (36a-36h) oder mittels Klebstoff befestigt ist und wobei das Membranelement (20a; 20b) an dem beweglichen Körper (22) mittels einer zweiten Vielzahl von Befestigungselementen (38a-38f) oder mittels Klebstoff befestigt ist.

8. Fluidbasiertes Kühlelement (10) nach einem der Ansprüche 4 bis 7, ferner umfassend eine erste Stützauflage (32) zum Stützen der inneren Umfangsregion des Membranelements (20a) und einer zweiten Stützauflage (34) zum Stützen der äußeren Umfangsregion des Membranelements (20a).

9. Fluidbasiertes Kühlelement (10) nach einem der Ansprüche 4 bis 8, wobei das Membranelement (20a; 20b) eine akkordeonartige Querschnittsform hat.

10. Fluidbasiertes Kühlelement (10) nach Anspruch 2 oder 3, wobei das verformbare Element (20a; 20b; 20d; 20d) ein rechteckförmiges Dichtungselement (20c) ist, das zwischen einer äußeren Seitenfläche (25c) des beweglichen Körpers (22) und einer inneren Seitenfläche (15b) des befestigbaren Basiskörpers (14) angeordnet ist.

11. Fluidbasiertes Kühlelement (10) nach Anspruch 10, wobei der bewegliche Körper (22) eine Umfangsaussparung (23) hat, die in der äußeren Seitenfläche (25c) des beweglichen Körpers (22) definiert ist, und wobei das rechteckförmige Dichtungselement (20c) von der Umfangsaussparung (23) für einen gleitenden Kontakt mit der inneren Seitenfläche (15b) des befestigbaren Basiskörpers (14) aufgenommen ist.

12. Fluidbasiertes Kühlelement (10) nach Anspruch 10 oder 11, wobei das rechteckförmige Dichtungselement (20c) ausgebildet ist, um die Fluidkammer (42) derart abzudichten, dass ein Austreten des von der Fluidkammer (42) aufgenommenen Kühlfluids verhindert wird.

13. Fluidbasiertes Kühlelement (10) nach einem der Ansprüche 2 bis 12, ferner umfassend eine weitere Vielzahl von Abstandselementen (28a-28d), die an dem beweglichen Körper (22) befestigt sind, um den beweglichen Körper (22) an der Leiterplatte (200) mittels einer Vielzahl von entsprechenden federbelasteten Befestigungselementen (102) zu befestigen.

14. Fluidbasiertes Kühlsystem (100), umfassend mindestens zwei fluidbasierte Kühlelemente (10) nach einem der Ansprüche 1 bis 13, wobei jedes der mindestens zwei fluidbasierten Kühlelemente (10) ausgebildet ist, um ein auf der Leiterplatte (200) angeordnetes einzelnes Wärmeerzeugungselement (202, 204) zu kühlen, wobei das einzelne Wärmeerzeugungselement (202, 204) jeweils eine vorbestimmte Höhentoleranz hat und wobei das fluidbasierte Kühlsystem (100) derart ausgebildet ist, dass jedes der einzelnen Wärmerzeugungselemente (202, 204) für jede Höhe der entsprechenden einzelnen Wärmeerzeugungselemente (202, 204) mit einer maximalen Kühlleistung gekühlt wird, wobei die genannte Höhe in einem vorbestimmten Bereich ist, der von der vorbestimmten Höhentoleranz definiert ist.

## Revendications

1. Élément de refroidissement à base de fluide (10) pour refroidir un élément générateur de chaleur (202, 204) agencé sur une carte de circuit imprimé (PCB) (200), dans lequel l'élément de refroidissement à base de fluide (10) comprend :
une chambre de fluide (42) pour recevoir un fluide de refroidissement ; et
un corps mobile (22) étant en contact fluidique avec la chambre de fluide (42) sur un côté supérieur du corps mobile (22), dans lequel le corps mobile (22) a une partie de base (24) ayant une première surface inférieure (25a) orientée à l'opposé de la chambre de fluide (42) ;
**caractérisé en ce que** la première surface inférieure (25a) de la partie de base (24) du corps mobile (22) est configurée pour être en contact avec l'élément générateur de chaleur (202, 204) agencé sur la carte de circuit imprimé (200),
dans lequel un élément déformable (20a ; 20b ; 20c ; 20d) est en contact avec le corps mobile (22) pour supporter de manière mobile le corps mobile (22), de telle sorte que le corps mobile (22) est mobile vers ou à l'opposé de la chambre de fluide (42) dans une direction (P1, P2) perpendiculaire à une surface supérieure intérieure (43) de la chambre de fluide (42), de telle sorte que la position de la première surface inférieure (25a) de la partie de base (24) du mobile le corps (22) en contact avec l'élément générateur de chaleur (202, 204) agencé sur la carte de circuit imprimé (200) est ajustable en fonction d'une hauteur variable de l'élément générateur de chaleur (202, 204) agencé sur la carte de circuit imprimé (200), et
dans lequel l'élément déformable (20a ; 20b ; 20c ; 20d) est constitué d'un matériau de caoutchouc.

2. Élément de refroidissement à base de fluide (10) selon la revendication 1, comprenant en outre une pluralité d'éléments d'entretoise (12a-12d) pour fixer l'élément de refroidissement à base de fluide (10) à la carte de circuit imprimé (200), un corps de base pouvant être fixé (14), dans lequel la pluralité d'éléments d'entretoise (12a-12d) sont fixés au corps de base pouvant être fixé (14), et un corps d'étanchéité (16) fixé sur le dessus du corps de base pouvant être fixé (14), dans lequel le corps d'étanchéité (16) a une surface inférieure définissant la surface supérieure intérieure (43) de la chambre de fluide (42), dans lequel l'élément déformable (20a ; 20b ; 20c ; 20d) est configuré pour relier le corps mobile (22) au corps de base pouvant être fixé (14), et dans lequel le corps de base pouvant être fixé (14), le corps d'étanchéité (16), le corps mobile (22) et l'élément déformable (20a ; 20b ; 20c ; 20d) définissent ensemble la chambre de fluide (42).

3. Élément de refroidissement à base de fluide (10) selon la revendication 2, dans lequel l'élément déformable (20a ; 20b ; 20c ; 20d) est configuré pour déplacer librement le corps mobile (22) par rapport au corps de base pouvant être fixé (14) dans une direction (P1, P2) perpendiculaire à une surface inférieure (15a) du corps de base pouvant être fixé (14), de telle sorte que la position de la première surface inférieure (25a) de la partie de base (24) du corps mobile (22) est déplacée par rapport à la position de la surface inférieure (15a) du corps de base pouvant être fixé (14).

4. Élément de refroidissement à base de fluide (10) selon la revendication 2 ou 3, dans lequel l'élément déformable (20a ; 20b ; 20c ; 20d) est un élément membrane (20a ; 20b) s'étendant depuis la surface inférieure (15a) du corps de base pouvant être fixé (14) vers une seconde surface inférieure (25b) de la partie de base (24) du corps mobile (22), dans lequel la seconde surface inférieure (25b) est en retrait par rapport au plan défini par la position de la première surface inférieure (25a) de la partie de base (24) du corps mobile (22).

5. Élément de refroidissement à base de fluide (10) selon la revendication 4, dans lequel l'élément membrane (20a ; 20b) s'étend depuis une région circonférentielle intérieure du corps de base pouvant être fixé (14) vers une région circonférentielle extérieure du corps mobile (22).

6. Élément de refroidissement à base de fluide (10) selon la revendication 4 ou 5, dans lequel l'élément membrane (20a ; 20b) est fixé sur le corps de base pouvant être fixé (14) dans une région circonférentielle extérieure de l'élément membrane (20a ; 20b), et dans lequel l'élément membrane (20a ; 20b) est fixé sur le corps mobile (22) dans une région circonférentielle intérieure de l'élément membrane (20a ; 20b) .

7. Élément de refroidissement à base de fluide (10) selon l'une des revendications 4 à 6, dans lequel l'élément membrane (20a ; 20b) est fixé au corps de base fixable (14) par l'intermédiaire d'une première pluralité d'éléments de fixation (36a-36h) ou par l'intermédiaire de colle, et dans lequel l'élément membrane (20a ; 20b) est fixé au corps mobile (22) par l'intermédiaire d'une seconde pluralité d'éléments de fixation (38a-38f) ou par l'intermédiaire de colle.

8. Élément de refroidissement à base de fluide (10) selon l'une des revendications 4 à 7, comprenant en outre un premier étrier de support (32) pour supporter la région circonférentielle intérieure de l'élément membrane (20a), et un second étrier de support (34) pour supporter la région circonférentielle extérieure de l'élément membrane (20a).

9. Élément de refroidissement à base de fluide (10) selon l'une des revendications 4 à 8, dans lequel l'élément membrane (20a ; 20b) a une forme de section transversale en accordéon.

10. Élément de refroidissement à base de fluide (10) selon la revendication 2 ou 3, dans lequel l'élément déformable (20a ; 20b ; 20d ; 20d) est un élément d'étanchéité de forme rectangulaire (20c) agencé entre une surface latérale extérieure (25c) du corps mobile (22) et une surface latérale intérieure (15b) du corps de base pouvant être fixé (14).

11. Élément de refroidissement à base de fluide (10) selon la revendication 10, dans lequel le corps mobile (22) a un évidement circonférentiel (23) défini dans la surface latérale extérieure (25c) du corps mobile (22), et dans lequel l'élément d'étanchéité de forme rectangulaire (20c) est reçu par l'évidement circonférentiel (23) pour venir en contact de manière coulissante avec la surface latérale intérieure (15b) du corps de base pouvant être fixé (14).

12. Élément de refroidissement à base de fluide (10) selon la revendication 10 ou 11, dans lequel l'élément d'étanchéité de forme rectangulaire (20c) est configuré pour rendre étanche la chambre de fluide (42), de telle sorte qu'une fuite du fluide de refroidissement reçu par la chambre de fluide (42) est évitée.

13. Élément de refroidissement à base de fluide (10) selon l'une des revendications 2 à 12, comprenant en outre une pluralité supplémentaire d'éléments d'entretoise (28a-28d) fixés au corps mobile (22) pour fixer le corps mobile (22) à la carte de circuit imprimé (200) par l'intermédiaire d'une pluralité d'éléments de fixation chargés par ressort correspondants (102).

14. Système de refroidissement à base de fluide (100) comprenant au moins deux éléments de refroidissement à base de fluide (10) selon l'une quelconque des revendications 1 à 13, dans lequel chacun des au moins deux éléments de refroidissement à base de fluide (10) est configuré pour refroidir un élément générateur de chaleur individuel (202, 204) agencé sur la carte de circuit imprimé (200), dans lequel les éléments générateurs de chaleur individuels (202, 204) ont chacun une tolérance de hauteur prédéterminée, et dans lequel le système de refroidissement à base de fluide (100) est configuré de telle sorte que les éléments générateurs de chaleur individuels (202, 204) sont chacun refroidis avec une performance de refroidissement maximum pour chaque hauteur des éléments générateurs de chaleur individuels respectifs (202, 204), dans lequel ladite hauteur est dans une plage prédéterminée définie par la tolérance de hauteur prédéterminée.
